# EUROPEAN PATENT APPLICATION

(11) **EP 1 245 691 A2**
(43) Date of publication of application: **02.10.2002**
(21) Application number: 02010908.8
(22) Date of filing: 09.08.1999
(51) Int. Cl.: C23C 4/00, C23C 14/04, C23C 16/04

(54) **Mask material**

(62) Divisional of application: 99810714.8
(71) Applicant: Alstom, 75116 Paris (FR)
(72) Inventor: Beeck, Alexander, Dr., Orlando, Florida 32828 (US); Bögli, Andreas, 5430 Wettingen (CH); Fernihough, John, Dr., 5408 Ennetbaden (CH)
(74) Representative: Pöpper, Evamaria, Dr.

(57) **Abstract**

Disclosed is a mask material (6) for masking holes in a component, the mask material (6) made from a resin of a plastic containing particles or fibres of metal or oxide material. It can be used as mask material (6) for plugging cooling holes of a gas turbine component.

## Description

### FIELD OF INVENTION

The invention relates to a mask material according to the claim 1.

### STATE OF THE ART

Components such as gas turbine blades, vanes and other cooled parts often contain cavities that distribute cooling air to a plurality of holes in the wall of the part that lead to the outer surface. Most turbine components are coated for protection from oxidation and/or corrosion with, for example, a MCrAIY coating (base coat) and some are also coated with a thermal barrier coating (TBC) for thermal insulation. The demands of operation of the parts in a gas turbine often lead to the degradation of the coating before the structural integrity of the underlying part itself is degraded. Hence, the base coat and TBC must be removed and re-applied.

The re-application of the coatings can be very problematic for parts with a large number of cooling holes. Often the base coat can reach thicknesses of 150-300 µm, and the TBC may be another 200 - 500 µm in thickness. The combined thicknesses of these coatings would have a very significant (and negative) influence on the effectiveness of the cooling holes if the coatings were deposited into these holes, especially considering that some holes are 1 mm or less in diameter. Specially shaped cooling holes are particularly susceptible to this as their effectiveness depends heavily on the accuracy of the shape of the hole.

There have been several disclosures relating to this problem and there are several widely known practices. Those skilled in the art are aware that a common practice is to braze or weld the holes closed with a suitable material after the old coatings have been removed, re-apply the new coatings, and re-manufacture the holes. The problem with this is that the brazing or welding operations introduce zones of weakness into the material. Normal hole manufacturing operations have errors associated with the placement of the holes, and when residual welding or brazing material is left, the zones of weakness go into operation with the part and compromise the mechanical integrity of the part.

One disclosure which offers a solution to this is US 5,702,288, in which an abrasive slurry is injected into the cavity of the component and forced through the cooling holes which were partially covered by the coating material. There was no welding or brazing closed prior to coating. However this also abrades the internal cooling configuration (ribs), any inserts, and also the non-coated portion of the cooing holes.

Another disclosure which offers a better solution is US 4,743,462, in which fugitive plugs are inserted into the cooling holes and partially volatilize during the coating process. The volatilization disrupts the coating in the region of the hole, and once the plugs are completely removed the holes are essentially free of coating and the cooling air will be unimpeded. The disadvantage of this method is that the large portion of the plug which blocks the surface does not constitute an even continuation of the cooling passage (it is specified to be larger than the cooling hole opening), therefore the path of the cooling air will be different from the intention of the original cooling holes design. This is particularly true for film cooling holes and specially shaped holes which are highly dependent on the shape of the hole near the external surface of the part. If the walls of the cooling holes are not maintained straight all the way through the coating layers (again, MCrAIY and TBC may amount to 0.8 mm or more in thickness) the cooling efficiency will be significantly compromised.

A further disadvantage of the method disclosed in US 4,743,462 is that the plugs must all be placed individually into the cooling holes. For small simple aero-engine parts such as the one illustrated in the disclosure (containing only several rows of cooling holes at the leading edge) this is feasible, however for large turbine components of land-based gas turbines which may contain several hundred cooling holes, it is no longer feasible to individually place plugs into each hole. This is further complicated by the fact that each component may be manufactured with several different types of cooling hole - including conical, straight cylindrical and holes with changing wall angles. Each type of cooling hole would require its own specially designed plug.

A further disclosure in which all holes are plugged at once is given in US 5,800,695. A masking agent is placed into the cooling configuration and forced through until it fills the cooling holes from the inside, but only up to the level of the exterior surface of the component. A coating is then applied, in this case electrolytically applied platinum. Due to the non-conductivity of the plastic maskant cited in the disclosure, no Pt would deposit on the masking agent in the cooling holes. However, if the coating were deposited using thermal spraying techniques, it would coat over the maskant in the cooling holes, forming a layer that would remain after maskant removal. This layer would have to be removed. No solution is offered for this problem - in particular, how to remove the layer of coating material in such a way that the intended cooling hole design is maintained through the thickness of the coating material.

In addition, only plastic materials are specified as maskant materials, and in US 4,743,462 the mask material is specified to volatilize at a temperature below that of the deposition process. The problem with this is that part requiring a MCrAIY coating and TBC must have the MCrAIY coating "diffusion bonded" by a high temperature heat treatment (about 1000°C - 1150°C in vacuum) before the TBC can be applied. These specified materials would not be retained for the TBC coating process, and would either have to be re-applied, or the advantage of the masking would be lost. Indeed, in patent US 5,800,695 the example process clearly states that after electrolytic platinum coating, the maskant is removed and then the parts are aluminized, with no mention of protecting the cooling holes from Al deposition.

### SUMMARY OF THE INVENTION

It is object of the present invention to find a process of masking all cooling holes of a gas turbine component at once, with the mask defining the walls of the cooling holes beyond the external surface of the component so that the deposited coating material forms the intended shape of the cooling hole.

According to the invention a process was found of masking cooling holes of a gas turbine component with an external surface, comprising a cavity and a plurality of cooling holes, before coating the gas turbine component, characterised in that Process of masking cooling holes of a gas turbine component with an external surface, comprising a cavity and a plurality of cooling holes before coating the gas turbine component, characterised in that masking of both the external surface of the component and the cooling holes with a mask material, exposing the cooling holes to at least one energy source from the cavity of the component and thereby thickening the mask material within the cooling holes and along the line-of-sight through the cooling holes beyond the external surface of the component, removing mask material unaffected by the energy source from the external surface of the component, coating the component and the masked cooling holes and removing the thickened mask material from the cooling holes.

The most important improvement of the present invention over the prior art is that the cooling holes are re-formed during the coating deposition processes to their originally intended design, even through the thickness of the applied coating. In addition, the "line-of-sight" concept is a novel and very important part of the process. Due to the manufacturing process with which the cooling holes are produced, which will be normally laser drilling, the "line-of-sight" of energy along the cooling holes from within the cavity of the component will very closely re-produce the original hole design above the external surface of the part through thickness of the coatings to be applied. Different energy sources and different mask materials may be used with special advantage for the process of the invention. The mask material may contain particles of solid material so that after thickening and with the proper heat treatment to volatilize part of the mask material, a porous solid form is left which can withstand the high temperatures of the diffusion heat treatment necessary for the bonding between base material of the component and the MCrAlY coating, before applying the thermal barrier coating (TBC). An other advantage is achieved when an insert is placed into the cavity of the component to avoid liquid mask material entering into the cavity and then thickening. It is possible that insert itself is the source of energy, which offers certain advantages.

### SHORT DESCRIPTION OF THE DRAWINGS

It is shown by
- **Fig. 1**: gas turbine blade with cooling configuration,
- **Fig. 2**: section by line II-II through the turbine blade shown in figure 1, comprising a cavity and a plurality cooling holes,
- **Fig. 3a**: first step of the process of the invention, applying mask material the external surface of the component and the cooling holes of the component, shown as an example at one cooling hole,
- **Fig. 3b**: second step of the process of the invention, thickening the mask material in the cooling holes and line-of-sight through the cooling holes beyond the external surface of the component by means of an energy source from the cavity of the component,
- **Fig. 3c**: third step of the process of the invention, removing remaining liquid mask material from the external surface of the component,
- **Fig. 3d**: fourth step of the process of the invention, depositing the coating on the external surface of both the component and the masked cooling holes,
- **Fig. 3e**: fifth step of the process of the invention, the component after the removing the thickened mask material from the cooling holes and
- **Fig. 4**: a component with an insert within the cavity to avoid excessive mask material coming through the cooling with the insert usable as energy source at the same time.

The drawings show only the parts important for the invention. Same elements will be numbered in the same ways in different drawings.

### PREFERRED EMBODIMENT OF THE INVENTION

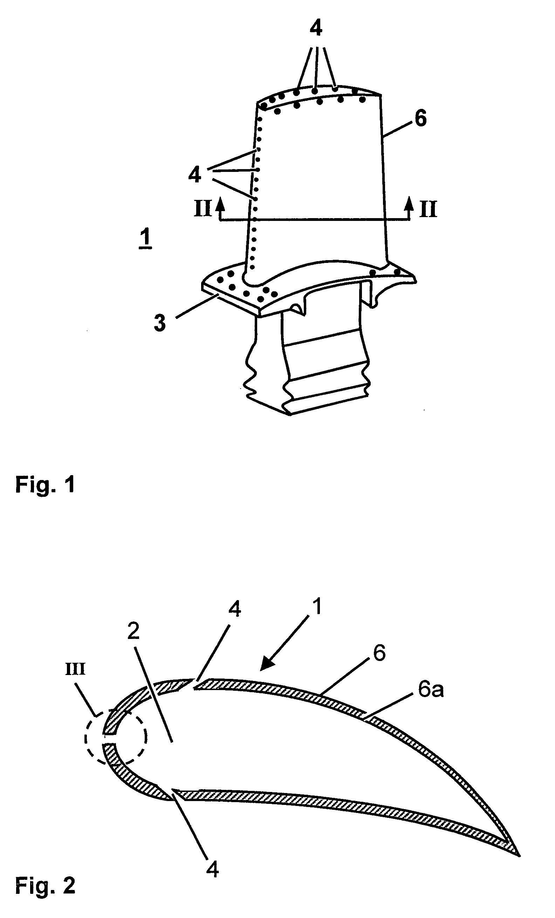

Figure 1 shows a component 1 such as blades or vanes of gas turbine engines comprising a cavity 2, not visible in figure 1, and cooling holes 4, which are on the external surface 6 of the component 1 as well as on the platform 3 of the component 1. The present invention relates to a process of masking cooling holes 4 in the component 1 before the deposition of coating material on the external surface 6 of the component 1 will take place.

According to line II-II in the figure 1 figure 2 shows a section through the component 1. The component 1 comprising a cavity 2 and three cooling holes 4. The number of the cooling holes 4 is given only as an example and may vary on the purpose the component 1 is used for. The component 1 has an external surface 6 and an internal surface 6a.

It is possible to apply the process for the coating of a new component 1 as well as to a component 1 which has to be repaired after use. In that case an already coated component 1 will by any means (chemical stripping with HCI, waterjet, high speed machining) be stripped of the coating to reveal the surface of the component 1. The external surface 6 of the component 1 and surfaces of the cooling holes 4 may be cleaned or otherwise prepared to receive the mask material 5.

The steps of the process of the invention are given in figures 3a to 3e, which show a cooling holes 4 from the component 1 in detail as given as an example in the circle III in the figure 2.

The figure 3a shows the first step of the process according the invention. The external surface 6 and the cooling holes 4 are masked with the mask material 5. It will be coated with, sprayed with, or immersed in a material which is at least partially liquid, the mask material 5, and which thickens, which means to become more viscous or solid when exposed to an energy source 7. A way it may be done is to inject the mask material 5 into the cooling cavity 2 of the component 1 and force it through the cooling holes 4. Excess mask material 5 may be removed afterwards from the internal surface 6a (which can be the cavity 2 or one side of the platform 3 not to be coated) of the component 1 before the application of an energy source 7.

As mask material 5 different substances may be used:
1. a organic material or
2. a resin of a plastic, such as polyurethane, a polyurethane oligomer mixture, poly(isobutyl methacrylate), poly(vinyl toluene), polypropylene or a polypropylene / polyurethane oligomer mixture and the class of polymers vetones or silicones, or any photo-polymerizing resin or mix of resins.
3. the mask material 5 may also be a substance that is not at least partially liquid but rather a powder, which means a collection of solid particles. Thickening of the powder then refers to the agglomeration and the sticking together to form clumps or a large solid mass of individual powder particles. The powder would have to be sensitive to an energy source 7, which means that the powder particles agglomerate under the influence of the energy source 7.

The mask material 5 may contain particles or fibres of metal or oxide material such as silica, magnesia, calcia, alumina, zirconia, yttria or a mixture there of.

The mask material 5a thickened from the energy source 7 containing the metal or oxide particles may further be heated so as to volatilize or otherwise remove the organic portion of the thickened mask material 5a before the coating 8 are deposited on external surface 6 of the component 1. There may be included in the resin binding agents which are effective in holding together the solid particles of metal or oxide after the organic portion of the mask material 5a is removed.

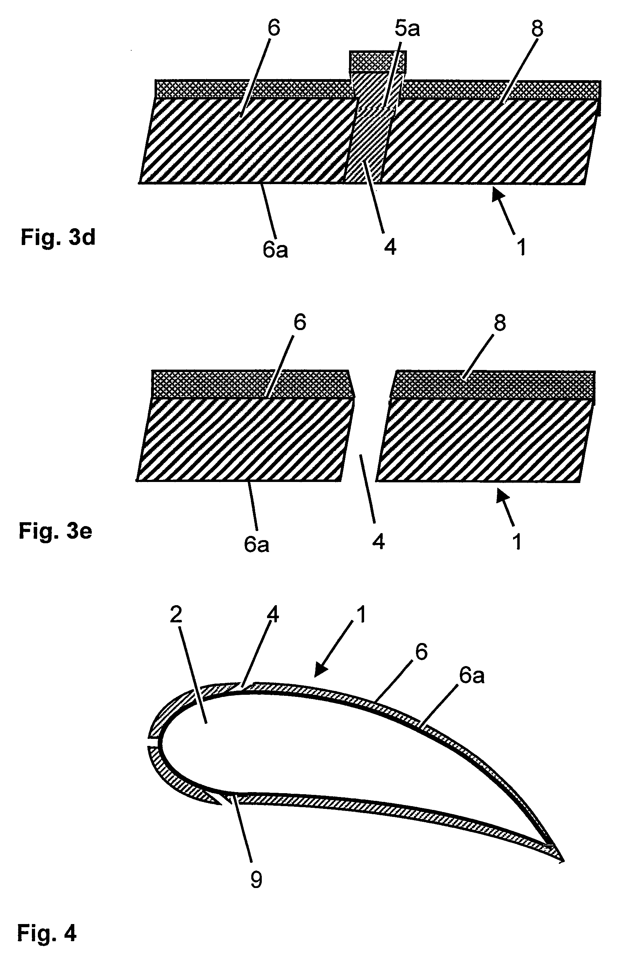

Figures 3b shows the second step of the process according the invention. The desired energy source 7 will be placed on the side of the internal surface 6a so that the energy impinges directly on said mask material 5 which is in the cooling holes 4 and that portion of the mask material 5 which lies outside of the cooling holes 4 but is located essentially along a line-of-sight from inside the component 1 through the cooling holes 4. Figures 3b shows the thickened material 5a as well. In this way, the mask material 5 may be thickened to a desired length extending beyond the external surface 6 of the component 1 but along the line-of-sight through the cooling holes 4 of the component 1. The mask material 5 which lies on the external surface 6 of the component 1 and not in the aforementioned line-of-sight will not be thickened by the energy source 7, or will be thickened to a much lesser extent, and will be preferentially removed before the deposition of the coating material 8 as shown in figures 3d.

Different energy sources 7 may be used in order to obtain the desirable result:
1. it can be electromagnetic such as visible light, ultraviolet light or infrared light,
2. it can be a device providing collimated light such as a laser,
3. the energy source 7 can also be a device providing light of a single wavelength or a distribution of wavelengths centered around a desired wavelength with a narrow distribution band,
4. furthermore the energy source 7 may be introduced into the cavity 2 of the component 1 via an optical fiber or
5. the energy source 7 can be sonic vibrations ranging from infrasonic (below 20 Hz) to ultrasonic (above 20,000 Hz) frequencies. Is this case the energy source can be a transducer (i.e. an ultrasonic transducer).

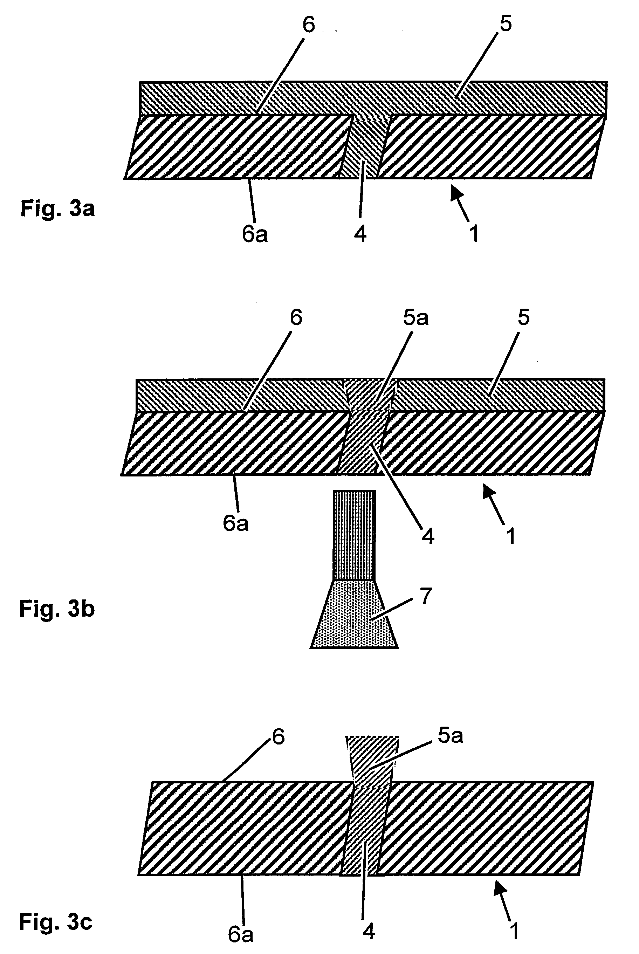

Figure 3c shows the component 1 after the removal of the liquid mask material 5. The thickened mask material 5a in the cooling holes 4 and extending beyond the cooling holes 4, but along the line-of-sight through the cooling holes 4, will be left in place to prevent blocking of the cooling holes 4 during deposition of the coating material(s) 8, which can be as an example MCrAIY and TBC. Other coating materials 8 are possible.

The mask material 5 will be thickened to a length beyond the external surface 6 of the component that is at least equal to the thickness of the coating(s) 8 to be deposited, with a preferred length of 200% to 300% of the intended coating thickness. The mask material 5 may contain particles of solid material so that after thickening and with the proper heat treatment to volatilize part of the mask material 5, a porous solid form is left which can withstand the high temperatures of the diffusion heat treatment necessary for the bonding between base material of the component 1 and the MCrAIY coating, before applying the thermal barrier coating TBC. For elongated cooling holes, there may be inserted materials that are essentially transparent to the energy source 7 so that the length of reacting mask material 5 through which the energy must travel from inside the cavity of the component is not excessive.

Due to the different shapes of cooling holes, some may "grow" thickened mask material 5a outside of surface 6 of the cooling hole 4 faster than other cooling holes 4. It may therefore be appropriate to remove residual thickened mask material 5a (above the desired length beyond the external surface 6 of the component) from some cooling holes 4 prior to the deposition of the coating material(s) 8. This may be done, for example, by mechanical means.

As seen in figure 3d the plating of the coating 8 on the external surface 6 will take place directly on the masked cooling holes 4 with the means known in the state of the art.

After the coating process(es) are completed, the thickened mask material 5a will be removed to reveal cooling holes 4 essentially free of coating material 8 and with walls that run consistently through the newly deposited coating material 8. This is shown in figure 3e. For example the removal of the thickening organic mask material can be accomplished by heating the part to 600°C in a vacuum furnace for 2 hours.

Beside the energy source 7 used it might be an advantage to place an insert 9 to the internal surface 6a within the cavity 2 of the component 1 as shown in figure 4. The insert 9 is essentially transparent to the type of energy used or the insert re-distributes or re-directs the energy from the energy source 7. In a preferred embodiment the insert 9 itself is the source of the energy 7, being specially shaped to fit into the cavity 2 of the component 1 to avoid excessive mask material 5 from thickening in the cavity 2. The insert 9 may have a special coating which allows the easy withdrawal from the component cavity 2 once the mask material 5 has been thickened.

It is possible that the component 1 is heated or cooled before or during processing to facilitate the polymerisation process.

The most important improvement of the present invention over the prior art is that the cooling holes 4 are re-formed during the coating deposition processes to their originally intended design, even through the thickness of the applied coating 8. In addition, the "line-of-sight" concept is a novel and very important part of the process. Due to the manufacturing process with which the cooling holes 4 are produced, which will be normally laser drilling, the "line-of-sight" of energy along the cooling holes 4 from within the cavity 2 of the component 1 will very closely re-produce the original hole design above the external surface 6 of the part through thickness of the coatings 8 to be applied.

### NUMBERING

- **1**: Component, e.g. blades or vanes for gas turbines
- **2**: Cavity
- **3**: Platform
- **4**: Cooling holes
- **5**: Mask material
- **5a**: Thickened mask material
- **6**: External surface
- **6a**: Internal surface
- **7**: Energy source
- **8**: Coating
- **9**: Insert

## Claims

1. A mask material (6) for masking holes in a component, the mask material (6) is made from a resin of a plastic containing particles or fibres of metal or oxide material.

2. The mask material (6) according to claim 1,
**characterised in that**
the plastic is a polyurethane, a polyurethane oligomer mixture, poly(isobutyl methacrylate), poly(vinyl toluene), polypropylene or a polypropylene / polyurethane oligomer mixture, the class of polymers vetones or silicones, or any photo-polymerizing resin or mix of resins.

3. The mask material (6) according to claim 1,
**characterised in that**
the particles or fibres of oxide material are silica, magnesia, calcia, alumina, zirconia, yttria or a mixture thereof.

4. The mask material (6) according to any of the claims 1 to 3,
**characterised in that**
the mask material (6) can be thickened by means of an energy source.

5. The mask material (6) according to claims 4,
**characterised in that**
the mask material (6) can be thickened by means of an ultra violet or infrared light.

6. The mask material (6) according to any of the claims 1 to 5,
**characterised in that**
the mask material (6) includes binding agents which are effective in holding together the solid particles of metal or oxide after an organic portion of the mask material (6) is removed.

7. The use of the mask material (6) according to any of the claims 1 to 6 for masking cooling holes of a gas turbine component during a coating application.
